**Europäisches Patentamt**

**European Patent Office**

**Office européen des brevets**

(11) Numéro de publication: **0 276 603 B1**

## FASCICULE DE BREVET EUROPEEN

(45) Date de publication de fascicule du brevet: **31.03.93**    (51) Int. Cl.[5]: **H04N 7/13**

(21) Numéro de dépôt: **87402890.5**

(22) Date de dépôt: **17.12.87**

(54) **Procédés de codage et de transmission d'un signal numérique, par rafraichissement temporel sélectif d'un quantificateur vectoriel.**

(30) Priorité: **17.12.86 FR 8617715**

(43) Date de publication de la demande:
**03.08.88 Bulletin 88/31**

(45) Mention de la délivrance du brevet:
**31.03.93 Bulletin 93/13**

(84) Etats contractants désignés:
**DE GB IT NL SE**

(56) Documents cités:

**IEEE INTERNATIONAL CONFERENCE ON ACOUSTICS, SPEECH, AND SIGNAL PROCESSING, Tampa, Florida, 26-29 mars 1985, vol. 1, pages 133-136, IEEE, New York, US; A. GERSHO et al.: "Adaptive vector quantization by progressive codevector replacement"**

**IEEE TRANSACTIONS ON COMMUNICATIONS, vol. COM-34, no. 7, juillet 1986, pages 703-710, IEEE, New York, US; M. GOLDBERG et al.: "Image sequence coding using vector quantization"**

(73) Titulaire: **FRANCE TELECOM**
**6, Place d'Alleray**
**F-75015 Paris(FR)**

Titulaire: **TELEDIFFUSION DE FRANCE**
**10, rue d'Oradour sur Glane**
**F-75932 Paris Cédex 15(FR)**

(72) Inventeur: **Labit, Claude**
**6, Square du Colonel Rémy**
**F-35700 Rennes(FR)**
Inventeur: **Marescq, Jean-Pierre**
**Route de Coutances**
**F-50190 Teriers(FR)**

(74) Mandataire: **Rodhain, Claude et al**
**Cabinet Claude Rodhain 30, rue la Boétie**
**F-75008 Paris (FR)**

**IEEE GLOBAL TELECOMMUNICATIONS CONFERENCE**, San Diego, California, 28 novembre - 1er décembre 1983, vol. 1, pages 184-187, IEEE, New York, US; B. RAMAMURTHI et al.: "Low-rate image coding using vector quantization"

**ELECTRONICS AND COMMUNICATIONS IN JAPAN**, vol. 69, no. 1, partie 1, janvier 1986, pages 75-84, Scripta Technica, Inc., New York, US; T. UDA et al.: "Picture coding by an adaptive multistage vector quantization"

## Description

Le domaine de l'invention est celui des procédés de codage des signaux numériques, dans lesquels on utilise des techniques de compression de données.

Plus précisément, l'invention concerne des procédés de codage dans lesquels la compression de données est réalisée par la technique connue de quantification vectorielle.

En effet, les techniques de compression de données ont pour objectif de réduire le débit d'informations à transmettre, en réaliser un codage d'élimination de redondances du signal numérique à transmettre, ou encore par appauvrissement de l'information transmise tout en respectant une certaine contrainte de qualité pour le signal numérique reçu.

La technique de quantification vectorielle répond à cet objectif en substituant à chaque composante du signal numérique d'entrée, représentée sous forme d'un vecteur de M variables, un vecteur représentant choisi parmi un ensemble prédéterminé et limité de vecteurs. Plus exactement, l'espace formé par l'ensemble des vecteurs possibles pour le signal numérique d'entrée est partitionné en un nombre réduit de cellules, regroupant chacune plusieurs vecteurs, et donc plusieurs états possibles du signal d'entrée. Tous les vecteurs d'une même cellule sont alors systématiquement représentés par un vecteur représentant unique de la cellule. Le signal numérique réellement transmis se limite donc à une succession de vecteurs représentants, préférentiellement codés chacun par un indice i de repérage. Cette technique réalise donc effectivement une compression du signal numérique d'entrée, par appauvrissement de l'information transmise. Dans le cas de la transmission d'un signal numérique audio ou télévisuel, une réduction relativement importante du débit d'information peut être réalisée, sans affecter la sensibilité psycho-auditive ou psychovisuelle du récepteur.

Bien entendu, le fonctionnement du système suppose que le récepteur puisse décoder le signal transmis, c'est-à-dire retrouver les caractéristiques du vecteur représentant correspondant à chaque indice i reçu. Cette fonction de décodage est réalisée par l'utilisation d'un tableau de correspondance indice/vecteur-représentant, appelé dictionnaire. Pour permettre un décodage en temps réel du signal transmis, le dictionnaire doit être préalablement transmis au récepteur, avant l'émission du signal numérique utile.

Les performances de cette technique connue de codage dépendent du mode d'élaboration du dictionnaire, et plus exactement du procédé de partitionnement d'une part, puis du choix du représentant de chaque cellule d'autre part.

On a tout d'abord résolu le problème du partitionnement en prédéterminant les cellules dans l'ensemble de tous les états possibles que peuvent prendre les vecteurs du signal numérique d'entrée. Ce type de codage, non adaptatif, est notamment décrit par L. Fortier, dans un rapport INRS intitulé "Quantification vectorielle du signal monochrome" ; Université du Québec, juillet 1984. Cette méthode de construction présente au moins deux types d'inconvénients majeurs, liés d'une part aux contraintes de construction du dictionnaire, et d'autre part à la précision de la quantification réalisée.

En effet, si l'on souhaite obtenir une bonne qualité d'image à partir du signal reçu, il est nécessaire de construire un dictionnaire important, ce qui suppose des temps d'élaboration élevés, ainsi que des temps de transmission substantiels. En outre, on ne peut élaborer un tel dictionnaire de façon fiable et rapide à partir du signal numérique d'entrée, que si ce signal est stationnaire et ergodique.

Pour ce qui est de la qualité du codage, et sauf à utiliser un dictionnaire extrêmement volumineux avec les inconvénients soulignés ci-dessus, on obtient en outre une distorsion non négligeable du signal particulièrement aux faibles débits. La précision de quantification est fixée dès le départ, et le dictionnaire est peu robuste pour le codage d'images de natures différentes.

Pour pallier ces inconvénients des techniques non adaptatives, on a également envisagé jusqu'à présent d'assouplir le partitionnement en permettant une redéfinition des cellules en fonction du signal numérique d'entrée instantané. Parmi les procédés adaptatifs les plus sophistiqués, on connaît le principe décrit par A. Gersho et M. Yano dans l'article "Adaptive Vector Quantization by Progressive Co-Devector Replacement" (Quantification vectorielle adaptative par remplacement progressif des représentants) paru en 1985 dans la revue IEEE, pages 133-136, vol. 1, 26-29 mars 1985, "International Conference on Acoustics, Speech and Signal Processing", Tampa, Florida, US. L'auteur y décrit un procédé de mise à jour du dictionnaire (rafraîchissement) pour le codage de portions d'images successives, en modifiant le représentant, voire le partitionnement lorsque la distorsion moyenne partielle de la cellule franchit un seuil prédéterminé. La modification du paritionnement consiste, le cas échéant, à scinder une cellule en deux, en supprimant un représentant peu utilisé pour maintenir le débit constant.

Un autre procédé analogue de mise à jour du dictionnaire associé à des trames d'image est décrit dans l'article "Image Séquence Coding Using Vector Quantization" paru en 1986 dans la revue IEEE TRANSACTIONS ON COMMUNICATIONS, Vol. C -34, no.7, juillet 1986, pages 703-710, New-York, US; de Goldberg et al.

Toutefois, pour être efficace, ce réarrangement local suppose une variation lente des statistiques sur plusieurs intervalles d'adaptation, afin de ne pas nécessiter un débit additionnel trop important et de conserver un dictionnaire rafraîchi proche du dictionnaire optimal dans chaque intervalle. Un inconvénient supplémentaire de cette méthode adaptative est lié au fait que le rafraîchissement local du dictionnaire ne réalise pas réellement une reconfiguration du partitionnement. Les rafraîchissements sont réalisés indépendamment pour chaque cellule, sans processus de répercussion de la mise à jour sur les cellules adjacentes. Cette rigidité conduit à obtenir un partitionnement inadéquat, comportant des cellules mal adaptées, et parfois redondantes, voire inutiles pour un seuil de distorsion donné.

A côté du problème délicat de l'adaptation du partitionnement au signal numérique d'entrée sous la contrainte du débit d'information, se pose également le problème du choix d'un représentant adéquat pour chaque cellule.

Selon le principe de la quantification vectorielle, le choix du représentant s'effectue par minimisation de la distorsion moyenne sur les vecteurs de la cellule. Cette condition est usuellement exprimée en liant les distorsions à la distance Euclidienne entre vecteurs. Or, cette mesure de distorsion qui a le mérite de s'exprimer facilement analytiquement, ne reproduit pas fidèlement les mesures de distorsion subjectives dues à la perception visuelle.

La présente invention a pour objet de fournir un procédé de codage adaptatif d'un signal numérique qui permette de pallier les inconvénients mentionnés ci-dessus des systèmes existants.

Plus précisément, un premier objet de l'invention est de réaliser un procédé de codage adaptatif d'un signal numérique par quantification vectorielle, comportant un processus de rafraîchissement sélectif du dictionnaire, en tenant compte de l'influence de la reconfiguration de chaque cellule sur son environnement immédiat. En d'autres termes, l'objectif est d'introduire une souplesse et une adaptabilité du rafraîchissement, pour éviter que la reconfiguration d'une cellule introduise par effet secondaire des distorsions, ou encore des redondances parasites par rapport à son environnement immédiat.

Un second objet de l'invention est de fournir un procédé de codage qui remplisse l'objectif présenté ci-dessus, tout en minimisant le débit d'information nécessaire à la transmission du signal codé. En effet, l'un des objectifs d'application de l'invention, parmi les nombreuses autres applications envisageables, est d'utiliser le procédé de codage revendiqué pour la transmission de signaux d'image en télévision numérique, dont la fréquence d'échantillonnage est actuellement normalisée à 13,5 MHz.

Un objet complémentaire de l'invention est de fournir un procédé de codage qui soit compatible avec un regroupement des composantes du signal transmis selon une classification par type, chaque classe correspondant à un mode de traitement et une possibilité d'échantillonnage spécifiques. Le regroupement par classes doit pouvoir alors s'accompagner de la création de sous-dictionnaires indépendants correspondant à chaque classe; un choix judicieux de classification doit permettre de regrouper dans les mêmes classes les représentants susceptibles d'être échantillonnés par zone de façon à minimiser la taille du dictionnaire correspondant, et à réduire le débit d'information lors de la transmission du signal codé. Dans le cas de l'application de l'invention à un signal de télévision numérique, les classes peuvent alors être définies de façon à regrouper les types de composantes (blocs d'image) du signal codé, qui peuvent être fortement échantillonnées par zones, lesdites zones étant définies en respectant un seuil de perception psychovisuelle.

Un autre objet de l'invention est de fournir un tel procédé de codage adaptatif qui soit également utilisable pour le codage d'images à trames entrelacées.

Ces objectifs ainsi que d'autres qui apparaîtront par la suite sont atteints à l'aide d'un procédé de codage adaptatif d'un signal numérique par quantification vectorielle, du type consistant à partitionner en cellules l'espace des états possibles des composantes du signal, en choisissant un représentant unique pour chaque cellule, et à substituer à chaque composante du signal le représentant de la cellule à laquelle il appartient, l'ensemble des représentants qui résultent du partitionnement formant un dictionnaire, le procédé incluant un processus de rafraîchissement local du dictionnaire, dans lequel on sélectionne (54) les cellules pour lesquelles le codage d'un nouveau jeu de composantes du signal à l'aide du dictionnaire en cours se traduit par une distorsion supérieure à un certain seuil, caractérisé en ce que le processus de rafraîchissement local du dictionnaire comprend en outre les étapes suivantes :

- on explore (56) le contenu et l'occurrence d'emploi du dictionnaire par le nouveau jeu de composantes du signal sur chaque cellule ainsi sélectionnée, ainsi que sur le voisinage de ladite cellule sélectionnée constitué par au moins une cellule voisine à ladite cellule sélectionnée, et
- on reconfigure (57, 58, 59) le partitionnement local de ce voisinage considéré comme un ensemble de cellules interdépendantes par détermination d'un ou de plusieurs représentants (23) pour ledit

EP 0 276 603 B1

ensemble.

De façon préférentielle, ladite étape d'exploration et de reconfiguration du voisinage de la cellule sélectionnée consiste à distinguer d'une part un voisinage "très proche" (proximité immédiate), et d'autre part un voisinage "proche" (proximité simple), et à fusionner toutes les cellules dudit voisinage très proche avec recalcul du nouveau représentant commun pour obtenir une cellule fusionnée, puis à rafraîchir en interdépendance toutes les cellules dudit voisinage proche, y compris la cellule fusionnée.

De façon avantageuse, ledit rafraîchissement interdépendant est réalisé par emploi de l'algorithme LBG, et de technique de découpage (clipping) des cellules.

Dans un mode de réalisation préférentiel de l'invention, la quantification vectorielle utilisée est obtenue à l'aide d'un quantificateur vectoriel multiclasse, ledit dictionnaire étant constitué par la concaténation de sous-dictionnaires correspondant chacun à une des classes. Le rafraîchissement du dictionnaire est alors réalisé indépendamment pour chaque sous-dictionnaire.

D'autres caractéristiques et avantages de l'invention apparaîtront à la lecture de la description suivante d'un mode de réalisation préférentiel, et non limitatif de l'invention, appliqué à la télévision numérique pour des raisons purement illustratives, et des dessins annexés dans lesquels :
- la figure 1 représente le schéma général du procédé de codage-décodage de signaux numériques d'image par quantification vectorielle,
- la figure 2 illustre schématiquement le principe de partitionnement par quantification vectorielle d'un espace à deux dimensions,
- la figure 3 représente le schéma fonctionnel d'un enchaînement préférentiel d'étapes du procédé de codage selon l'invention,
- la figure 4 constitue une présentation systématique mettant en évidence les paramètres de fonctionnement du procédé de codage adaptatif selon l'invention,
- la figure 5 est un organigramme de présentation séquentielle du processus de rafraîchissement local d'un sous-dictionnaire, de l'étape 4 de la figure 3,
- la figure 6 illustre la mise en oeuvre de la reconfiguration d'une cellule en interdépendance avec son voisinage proche, dans le processus de rafraîchissement de la figure 5,

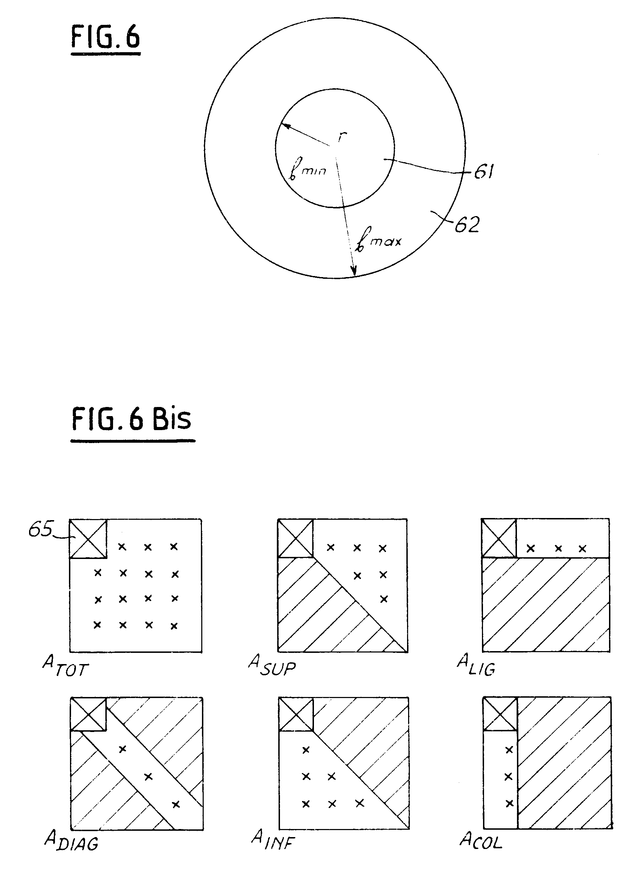

- la figure 6bis représente un jeu de grilles de classification de blocs d'image transformés soumis au codage adaptatif de l'invention;

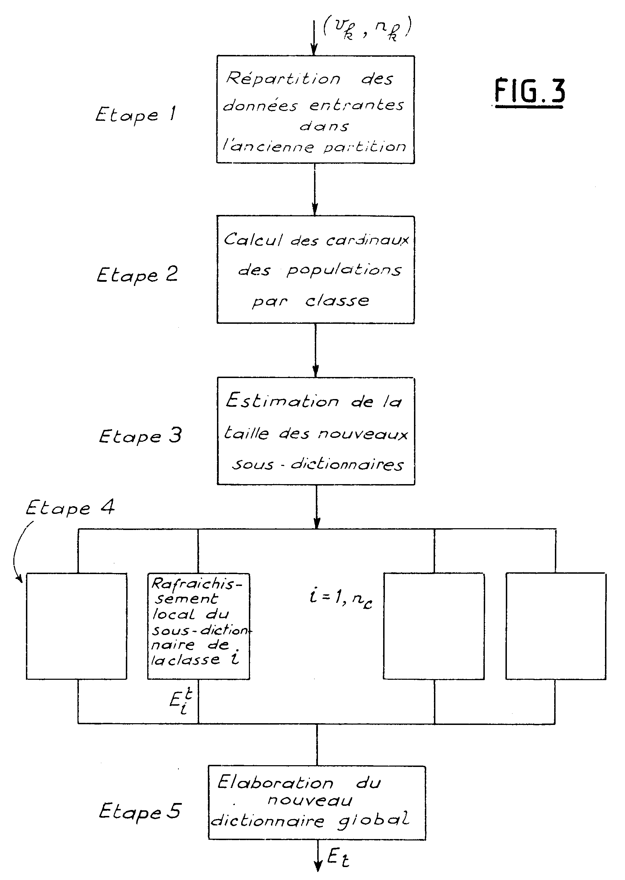

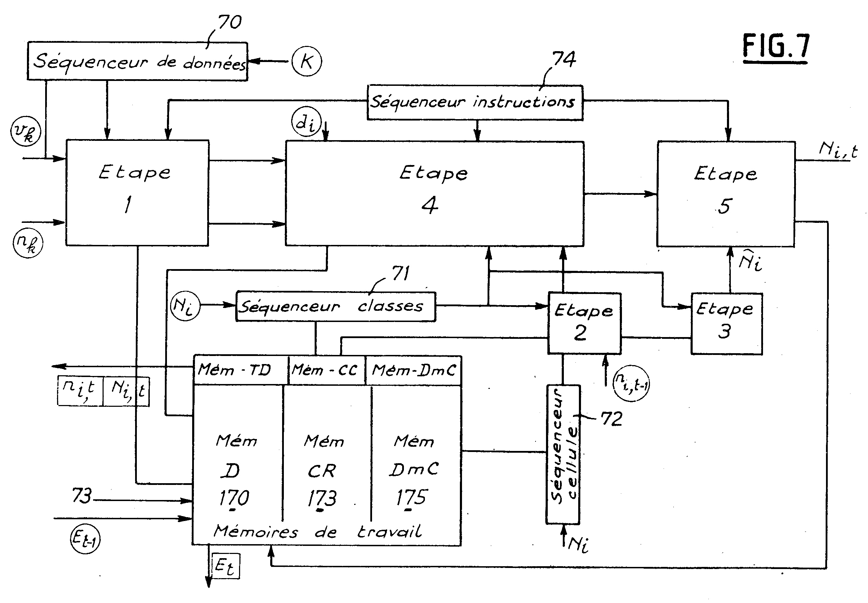

- la figure 7 est un diagramme synoptique illustrant les connexions de transfert de données entre les chaînes de circuits et modules mis en jeu pour la réalisation de chacune des étapes de la figure 3, dans un dispositif de mise en oeuvre du procédé selon l'invention ;

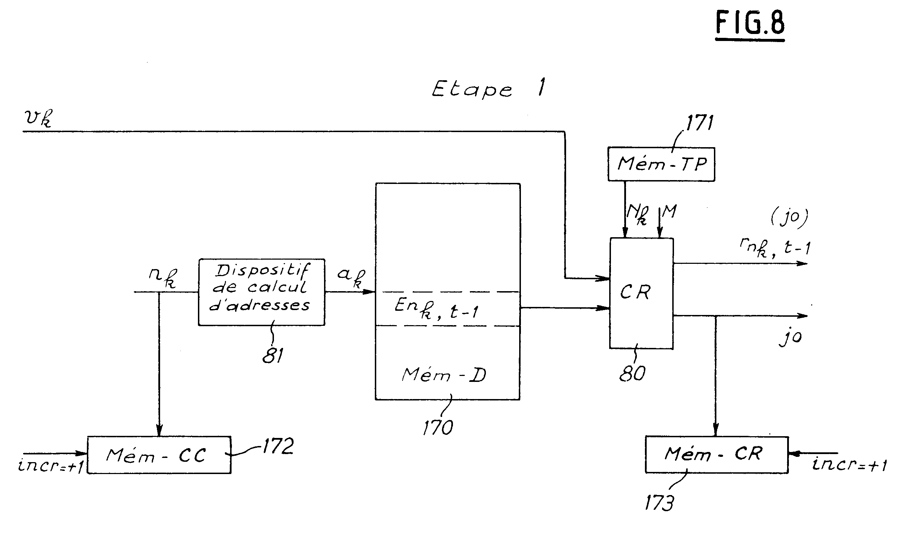

- les figures 8, 9, 10, 10bis et 11 détaillent les chaînes de circuits et modules correspondant à chacune des étapes du diagramme de la figure 7 ;

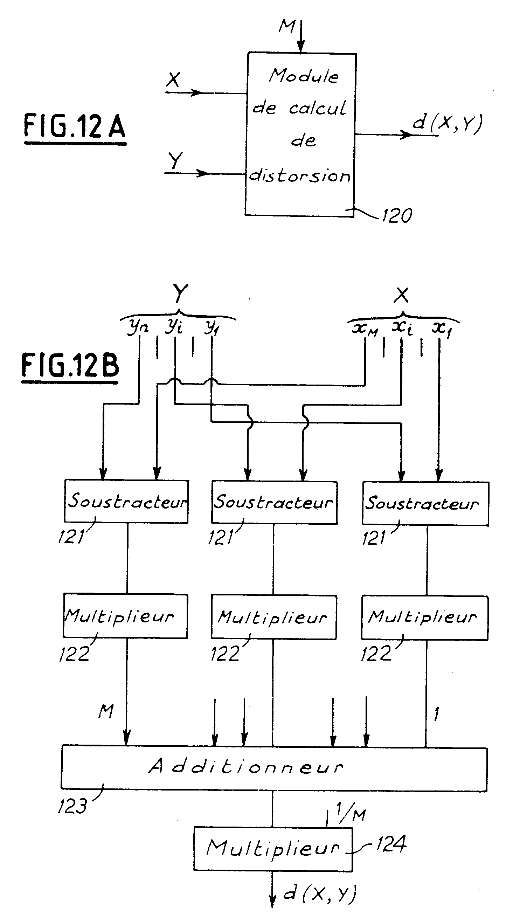

- les figures 12 à 17 détaillent les circuits composant les modules des figures 8 à 11 ;

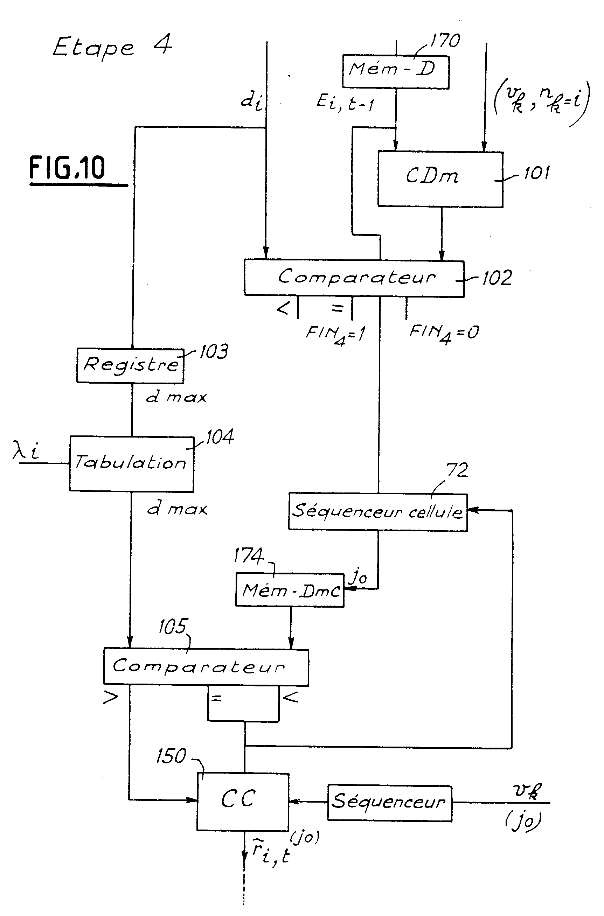

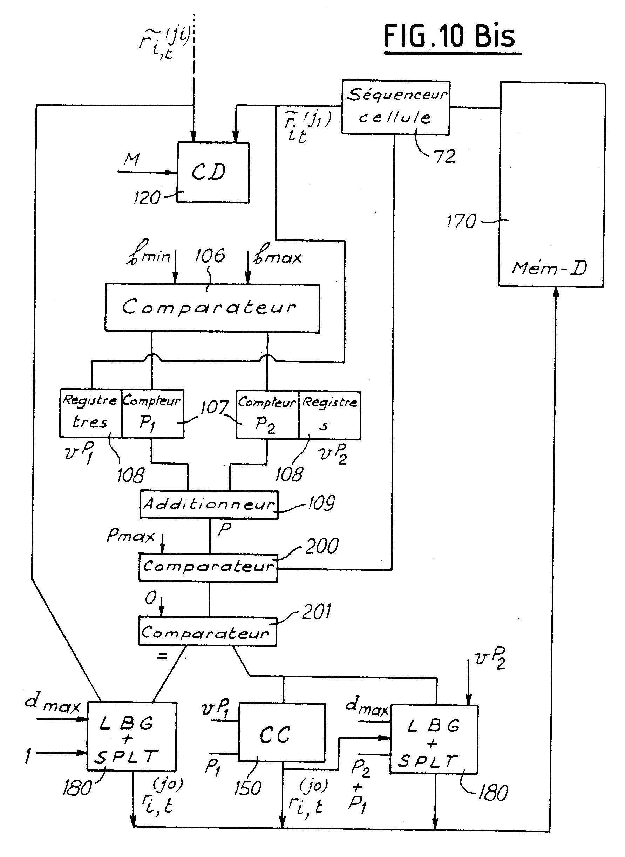

- la figure 18 représente un module de mise en oeuvre du rafraîchissement par algorithme LBG et techniques de découpage, représenté en Fig. 10bis.

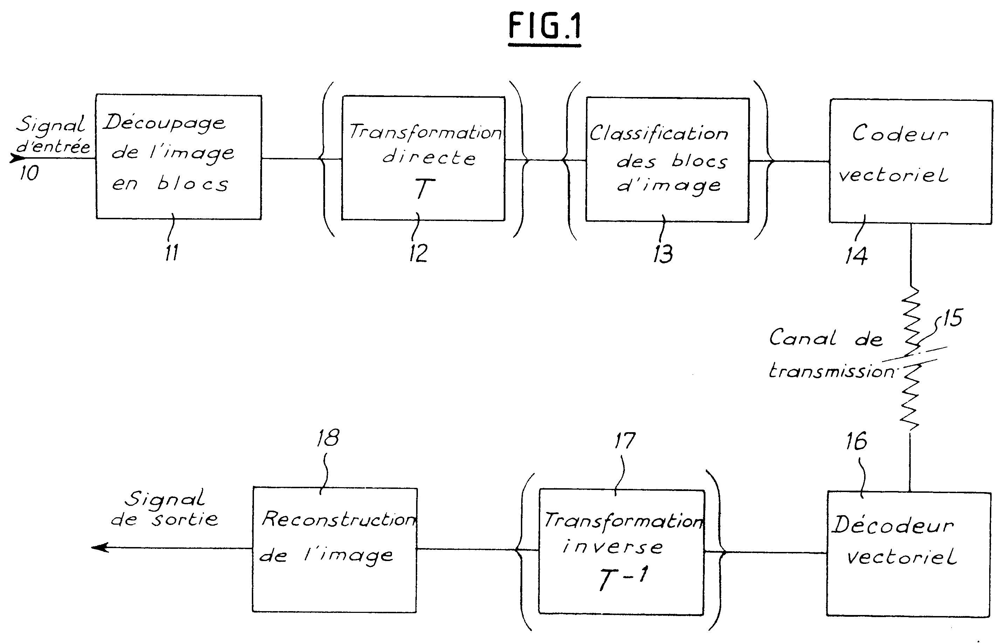

La figure 1 schématise un procédé de codage-décodage de signaux numériques d'images. Ce schéma permet de tracer le cadre de l'exemple de mise en oeuvre du procédé de codage adaptatif suivant l'invention, qui est maintenant décrit.

Bien qu'on se rapporte systématiquement ci-après spécifiquement au codage et la transmission d'images, notamment d'images de télévision, il est clair que le procédé de codage suivant l'invention est parfaitement applicable à tout autre type de signaux numériques.

Dans le procédé général représenté en figure 1, le signal d'entrée 10 est un signal d'image, qui va tout d'abord être découpé (11) de façon connue, en blocs d'image, par exemple en blocs de 4 x 4 pixels. Chaque bloc d'image constitue une composante du signal entrant 10.

La décomposition de l'image en blocs 4 x 4 pixels n'est pas une caractéristique limitative de l'application de l'invention au codage d'image. Toutefois, cette décomposition est tout à fait avantageuse, dans la mesure où une taille inférieure des blocs augmente le débit pour une même taille de dictionnaire, et une taille supérieure ne permet pas d'isoler nettement des configurations de blocs simples et augmente considérablement le temps d'élaboration du dictionnaire et de recherche des représentants.

Les blocs d'image peuvent être considérés comme des vecteurs dont les composantes sont les caractéristiques de chacun des pixels du bloc d'image. Les caractéristiques des pixels sont par exemple l'intensité seule dans le cas d'une image monochrome, ou bien encore la luminance et/ou la chrominance dans le cas d'un signal d'image couleur.

Le cas traité ci-après est le cas spécifique d'un signal d'image monochrome.

Les blocs d'image peuvent ensuite subir un prétraitement 12 avant codage.

5

La transformation orthogonale 12 consiste à associer à chaque bloc d'image un bloc transformé de mêmes dimensions, représentatif des composantes fréquentielles du bloc original. Chaque bloc transformé est un vecteur, dont l'un des coefficients est proportionnel à la moyenne des intensités sur le bloc, et les autres coefficients fournissent une information fréquentielle.

Les avantages de procéder à une transformation sont notamment de décorréler les composantes des vecteurs, de diminuer l'effet de moyennage dûs à la quantification vectorielle, ou encore, comme on le verra ci-après, d'échantillonner par zones le bloc codé pour diminuer le débit de transmission.

Les transformations orthogonales les plus utilisées sont celles de Slant, Hadamard et la transformation Cosinus. Cette dernière est la mieux adaptée aux caractéristiques du signal d'image.

Le prétraitement de classification 13 des blocs d'image permet de répartir les blocs par types, par exemple pour leur faire subir des traitements indépendants (parallèles), et spécifiquement adaptés à chaque classe.

Un exemple de classification de blocs de coefficients transformés consiste à répartir les blocs parmi les types suivants : blocs homogènes, blocs de contours horizontaux, verticaux, à texture bruitée ou non bruitée, etc.

Dans la procédé de codage suivant l'invention, la classification des blocs permet de moduler le débit partiel de chaque classe sans pénaliser les autres, en "collant" au plus près à la sensibilité du système visuel qui est différente suivant les configurations des blocs. En calculant un dictionnaire pour chaque classe définie, on ajoute en outre deux effets intéressants : l'effet de moyennage est réduit, ce qui procure un meilleur rendu visuel, et le coût calcul est inférieur au cas du traitement de l'image globale.

Après prétraitement 12,13, qui peut inclure également d'autres traitements non décrits, le signal numérique d'entrée est alors constitué de doublets : $(v_k, n_k)$, où $v_k$ est le k ième vecteur de signal entrant, et $n_k$ est le numéro de la classe à laquelle le vecteur $v_k$ appartient. C'est ce flot temporel de données que nous considèrerons comme entrantes pour l'exemple de mise en oeuvre du procédé décrit ci-après.

Les doublets $(v_k, n_k)$ sont traités par quantification vectorielle dans le codeur vectoriel 14. Comme déjà mentionné précédemment, la quantification vectorielle permet d'effectuer une transmission 15 en compression de données. Chaque vecteur est en effet transmis simplement sous forme de l'indice du rang de son représentant dans le dictionnaire.

A la réception du signal codé, les opérations inverses de décodage 16, de transformation inverse 17 et de reconstruction de l'image 18 sont exécutées. Le décodage 16 suppose la transmission préalable du dictionnaire.

L'un des avantages essentiels du procédé de codage décodage représenté en figure 1 est que, quelle que soit la complexité de l'opération de codage réalisée en amont du canal de transmission 15, l'unité de réception 16, 17, 18 est extrêmement légère : la partie complexe du décodage est en effet concentrée dans le dictionnaire, dont la transmission et le stockage sont peu contraignants du point de vue de l'unité de réception.

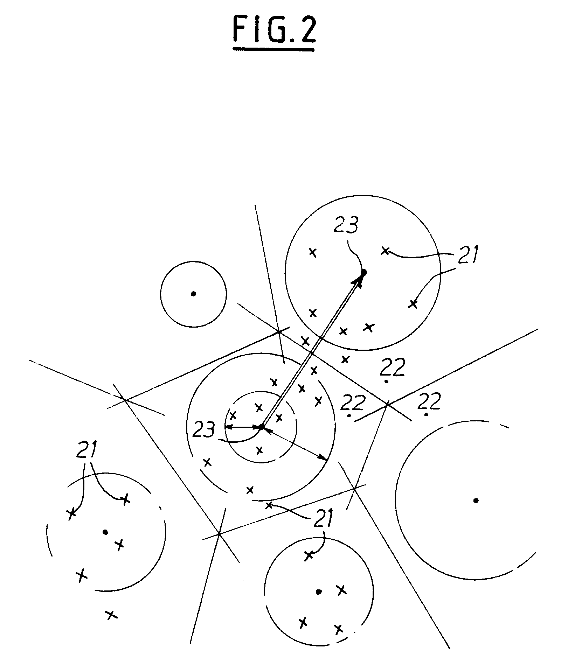

La figure 2 illustre le partitionnement de l'espace des états possibles des vecteurs (blocs d'image transformés) par quantification vectorielle. Bien que le partitionnement représenté en figure 2 soit schématisé dans un espace à deux dimensions, il faut comprendre que la quantification vectorielle du codeur 14 de la figure 1 agit en dimension M, M représentant le cardinal de chaque vecteur.

Comme on peut le voir en figure 2, le partitionnement consiste à répartir les vecteurs 21 dans des cellules 22, centrées chacune autour d'un vecteur représentant 23. La construction des cellules 22 s'effectue suivant une règle de minimisation de la distorsion résultant de la substitution du représentant 23 à chaque vecteur 21 de la cellule. Le calcul de la distortion est typiquement un calcul de distance euclidienne entre chaque vecteur 21 et son représentant 23.

L'introduction d'une classification, dans le codage adaptatif suivant l'invention, permet de moduler le seuil de distorsion acceptable pour la construction spécifique du sous-dictionnaire de chaque classe.

La figure 3 schématise un enchaînement préférentiel d'étapes de rafraîchissement du dictionnaire, selon le procédé de codage de l'invention :

- l'étape 1 consiste à admettre un jeu de vecteurs d'observation $(v_k, n_k)$, destinés à tester le dictionnaire $E_{t-1}$ en cours. Ce jeu de vecteurs d'observation peut être constitué par la totalité de la nouvelle image, ou de la nouvelle trame à transmettre. Toutefois, le jeu d'observations peut n'être constitué que d'un échantillon de la nouvelle image, pourvu que les signaux correspondants soient stationnaires et ergodiques.

- les étapes 2 et 3 reviennent à estimer la taille des nouveaux sous-dictionnaires, par calcul des cardinaux des populations par classe . Autrement dit, le procédé illustré en figure 3 commence par compter l'occurence d'emploi de chaque sous-dictionnaire par la séquence de vecteurs d'observation.

Lorsque le rafraîchissement du dictionnaire doit s'effectuer sous contrainte d'une taille maximale du dictionnaire, l'estimation de la taille de chacun des nouveaux sous-dictionnaires permet de prévoir pour chacun d'eux le nombre approximatif de représentants qu'ils pourront contenir.

Les étapes 2 et 3 et 5 de la figure 3 ne constituent en aucune façon une caractéristique limitative de l'invention. Ces étapes peuvent être ignorées, en l'absence de contraintes sur la taille du dictionnaire final concaténé, ou encore remplacées par tout algorithme adéquat.

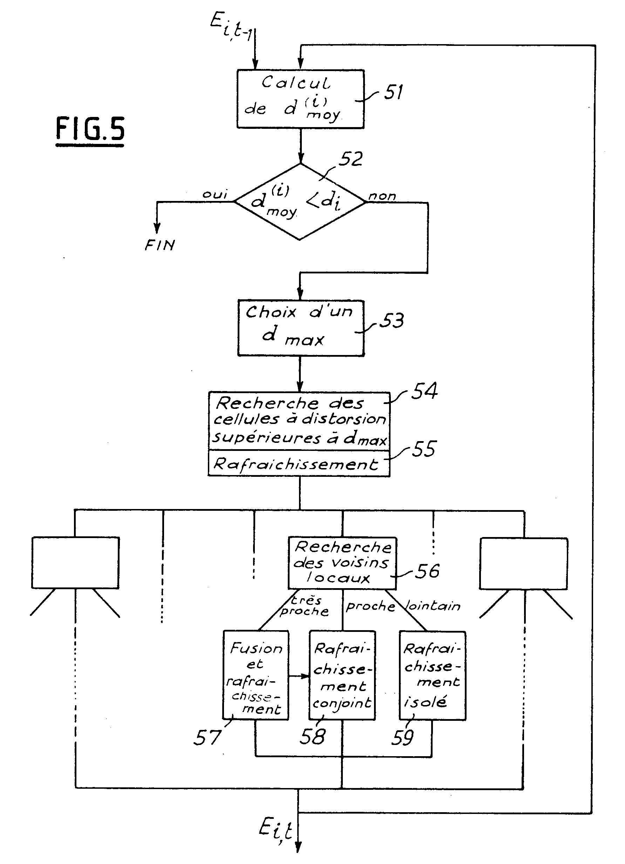

- l'étape 4 correspond au rafraîchissement sélectif des sous-dictionnaires $E_i^t$, exécuté indépendamment pour chaque classe i. Cette étape est expliquée plus en détail sur la figure 5.
- l'étape 5 finale consiste à concaténer tous les sous-dictionnaires rafraîchis à l'étape 4, pour obtenir le nouveau dictionnaire global $E_t$.

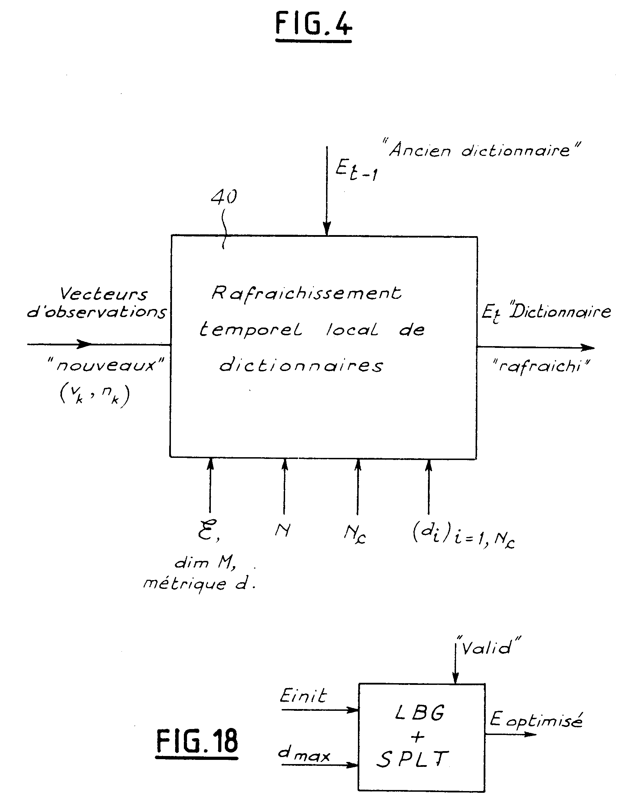

L'opération de rafraîchissement du dictionnaire est synthétisée en figure 4.

L'intrant principal du système de rafraîchissement 40 est l'ancien dictionnaire $E_{t-1}$, et l'extrant est le dictionnaire rafraîchi $E_t$.

Les paramètres de rafraîchissement sont les suivants :
- la séquence de vecteurs d'observation $(v_k, n_k)$ ;
- l'espace vectoriel de travail $\epsilon$ de dimension M, muni d'une métrique d ;
- la taille du dictionnaire global N ;
- le nombre de classes (donc de sous-dictionnaires): $N_c$ ;
- la distorsion maximale admissible par classes $(d_i)$.

La détermination préalable des distorsions maximales admissibles par classe s'effectue préférentiellement sur la base de critères psychovisuels.

La figure 5 présente l'organigramme d'un mode de réalisation préférentiel du procédé de rafraîchissement sélectif de chaque sous-dictionnaire. Ce processus correspond à l'un des processus parallèles de l'étape 4 de la figure 3.

Bien entendu, en l'absence de classification, le procédé de rafraîchissement de la figure 5 est appliqué uniformément à tout le dictionnaire.

La sélectivité du rafraîchissement est une des caractéristiques essentielles de l'invention. Cette sélectivité est assurée, dans le mode de réalisation de la figure 5, par l'intermédiaire d'un test 52 sur la distorsion moyenne du sous-dictionnaire, puis le cas échéant, par la réalisation d'un second test 54 destiné à rafraîchir les cellules à forte distorsion de façon à faire baisser la distorsion moyenne du sous-dictionnaire.

De façon essentielle, le rafraîchissement des cellules sélectionnées s'effectue en interdépendance avec son voisinage 56.

Le test 52 suppose le calcul préalable 51 de la distorsion moyenne

$$d_{moy}^{(i)},$$

distorsion calculée sur l'ancien sous-dictionnaire $E_{i,t-1}$, à l'aide des vecteurs de la séquence d'observation appartenant à la classe i.

Lorsque la distorsion moyenne du sous-dictionnaire est inférieure à la distorsion maximale admissible $d_i$, aucune opération de rafraîchissement n'est entreprise.

Dans le cas contraire, le sélection 54 des cellules à forte distorsion s'effectue après avoir choisi une valeur de distorsion maximale admissible par cellule $d_{max}$. De façon préférentielle $d_{max} = \lambda_i d_i$, le coefficient $\lambda_i$ pouvant se voir affecté des valeurs décroissantes par récursivité lorsque la distorsion moyenne

$$d_{moy}^{(i)}$$

ne revient pas en-deçà du seuil maximal admissible $d_i$ au cours de la première itération.

A l'étape 54 de sélection les cellules dont la distorsion est supérieure à $d_{max}$ subissent d'abord un premier rafraîchissement 55 par recalcul de chaque centroïde (représentant) de ces cellules. Le déplacement du représentant dans la cellule par rapport à sa position initiale est d'autant plus important que la topologie des nouveaux vecteurs de la séquence d'observation diffère de celle des vecteurs d'observation précédents.

Lorsque les cellules sélectionnées ont subi le premier rafraîchissement 55, le procédé suivant l'invention assure une exploration du voisinage de la cellule rafraîchie afin de réaliser une nouvelle partition locale.

Une des originalités du procédé suivant l'invention tient en effet à ce que chaque cellule rafraîchie est "réinsérée" localement pour éviter les distorsions qui résulteraient indirectement du rafraîchissement 55.

De façon avantageuse, on distingue trois niveaux de proximité, à savoir une proximité immédiate 57, une proximité simple 58 et une proximité lointaine 59. Cette distinction permet de lisser l'influence du rafraîchissement de la cellule sélectionnée sur son voisinage, par fusion de la cellule sélectionnée avec les cellules de son voisinage très proche, puis repartitionnement interdépendant de la nouvelle cellule fusionnée avec toutes les cellules proches. Le voisinage lointain 59 n'est pas pris en compte.

La figure 6 illustre le principe d'exploration du voisinage de chaque cellule sélectionnée. Le mode de réalisation représenté consiste à rechercher les P plus proches représentants voisins du représentant r de la cellule sélectionnée dans une boule incluse dans l'espace $\xi$ , centrée sur le représentant r et de rayon f fonction de la distorsion maximale admissible $d_i$. De façon avantageuse, le nombre de représentants cherchés est borné : $P \leq P_{max}$.

Les P plus proches représentants du représentant rafraîchi r peuvent être répartis en :

$p_1$ représentants identifiés dans le voisinage immédiat 61 : boule de rayon égal à fmin ;

$p_2$ représentants identifiés dans le voisinage proche 62 : boule de rayon égal à fmax.

Les stratégies de rafraîchissement sont définies en fonction des niveaux de voisinage. Dans le voisinage immédiat 61 est réalisée une fusion de l'ensemble des cellules identifiées, avec rafraîchissement par recalcul du centroïde sur l'ensemble fusionné.

La technique de rafraîchissement utilisée ensuite sur le voisinage proche 62, y compris la cellule fusionnée, est par exemple l'utilisation de l'algorithme de Linde, Buzo et Gray (algorithme LBG), et les techniques de découpage. De façon connue, l'algorithme LBG est une technique d'optimisation itérative d'un dictionnaire, pour un critère de distorsion donné, par exemple $d_{max}$. Les techniques de découpage visent à dédoubler une cellule initiale, notamment lorsque la distorsion moyenne sur la cellule dépasse un certain seuil acceptable.

Lorsque le voisinage de la cellule sélectionnée est vide ($P = P_1 = P_2 = 0$),on peut également employer l'algorithme LBG et des techniques de découpage pour optimiser la cellule fusionnée.

Lorsque toutes les cellules sélectionnées et rafraîchies des étapes 54, 55 ont été repartitionnées en interdépendance avec leur voisinage 56, 57, 58, 59, et que la distorsion moyenne du sous-dictionnaire est inférieure au seuil maximal $d_i$, le rafraîchissement du sous-dictionnaire est terminé.

Un exemple de mise en oeuvre du procédé de l'invention ainsi décrit peut être résumé dans l'enchaînement des phases 1 à 9 figurant en table 1.

TABLE 1
————

Exemple d'enchaînement de phases logiques mettant en oeuvre le procédé de rafraîchissement d'un sous-dictionnaire, suivant l'invention :

Phase 1 : Dictionnaire courant = dictionnaire de la
                trame précédente
                Répartition des vecteurs issus de la trame à
                coder et calcul de la distorsion moyenne $D_{moy}$
                Si $D_{moy} \leqslant$ seuil acceptable, pas de rafraîchissement
                Sinon continuer

Phase 2 : Fixer un seuil $D_{cellmax}$ de distorsion maximale
                admissible par cellule.

Phase 3 : Rafraîchir toutes les cellules dont la distorsion est supérieure à $D_{cellmax}$

Phase 4 : Pour chaque représentant rafraîchi et non déjà traité,
                Recherche du représentant le plus proche et
                Calcul de la distance $D_{vois}$ entre les deux représentants.
                Si $D_{vois} \leqslant D_{moy}$ exécution de la phase 5
                Si $D_{moy} < D_{vois} \leqslant 2,5 D_{moy}$ exécution de la phase 6
                Si $D_{vois} > 2,5 D_{moy}$ exécution de la phase 7

Phase 5 : Fusion des deux cellules et optimisation
                Exécution de la phase 8

TABLE I (Suite)

---

Phase 6 : Optimisation des deux cellules simultanément

Si la distorsion moyenne sur les deux cellules reste supérieure à $D_{cellmax}$, ajoût d'un représentant médian et optimisation

Exécution de la phase 8

Phase 7 : Optimisation de la cellule rafraîchie uniquement et ajout d'un représentant par découpage si la distorsion cellulaire est supérieure à $D_{cellmax}$

Exécution de la phase 8

Phase 8 : Si tous les représentants rafraîchis sont traités,

Exécuter la phase 9

Sinon, exécuter la phase 4

Phase 9 : Test sur la distorsion moyenne $D_{moy}$

Si $D_{moy}$ est inférieure au seuil de distorsion acceptable,

Suppression des représentants inutilisés.

Fin du rafraîchissement.

Sinon, $D_{cellmax} = D_{cellmax}/1,1$, et exécution de la phase 3

Lorsque tous les sous-dictionnaires ont été rafraîchis, il peut être nécessaire d'introduire une étape d'arbitrage avant concaténation, lorsque la somme des représentants rafraîchis dépasse la taille maximum admissible du dictionnaire. On notera que la taille admissible du dictionnaire peut être liée par exemple à la dimension de l'index de repérage des représentants.

De façon avantageuse, l'arbitrage entre les sous-dictionnaires est réalisé par élimination des représentants les moins utilisés. Toutefois, toute autre procédure d'arbitrage efficace est envisageable.

Comme on l'a déjà souligné précédemment, le choix de la méthode de classification des vecteurs est essentiel si l'on souhaite réellement optimiser le codage, c'est-à-dire préserver la meilleure qualité d'image possible sous la contrainte d'un débit d'information limité. Un des moyens intéressants de réaliser la classification 13 de la figure 1, de manière optimale par rapport au procédé de codage adaptatif des figures 3 et 5, consiste à utiliser des grilles d'analyse des blocs transformés du type de celles de la figure 6bis. Cette figure représente un jeu de six grilles de classification de blocs d'image 4 x 4 transformés, soumis au codage adaptatif de l'invention. On rappelle qu'après transformation orthogonale, chacun des seize coefficients d'un bloc transformé fournit une information de fréquence, à l'exception du coefficient 65 qui fournit une information de moyenne. Le coefficient 65 est traité séparément pour des raisons exposées plus haut.

Les grilles $A_{SUP}$, $A_{LIG}$, $A_{DIAG}$, $A_{INF}$, et $A_{COL}$ servent à calculer l'"activité" de chaque bloc d'image transformé dans une zone particulière (coin supérieur droit, première ligne, diagonale, coin inférieur gauche, première colonne). La configuration de ces grilles a été retenue après expérimentation de la distorsion psychovisuelle attachée à chaque grille, de façon que leur utilisation permette une classification optimale des blocs. Le jeu de classes que le jeu de grilles ainsi déterminé permet de construire autorise en effet notamment une adaptation optimale de l'échantillonnage par zones, sous la contrainte de maintenir la dimension finale des blocs de chaque zone à une même valeur, après échantillonnage. Il est clair que la possibilité de pouvoir ainsi échantillonner tous les blocs d'une même classe, et donc supprimer un certain nombre de leurs coefficients sans provoquer de distorsion sensible sur le signal d'image reçu, permet une économie en coût de traitement, et en coût de transmission du sous-dictionnaire de la classe.

De façon préférentielle, l'affectation de chaque bloc à une classe est réalisée par comparaison de l'activité du bloc dans la grille appliquée (c'est-à-dire l'activité du bloc en ne tenant compte que des coefficients se trouvant dans les zones non hachurées), par rapport à des seuils prédéterminés.

La figure 7 est un diagramme synoptique illustrant les connexions de transfert de données entre les chaînes de circuits et modules mis en jeu par la réalisation de chacune des étapes de la figure 3, dans un dispositif de mise en oeuvre du procédé suivant l'invention.

Les cinq étapes du procédé, dont les circuits et modules correspondants sont détaillés dans les figures 8 à 11 (l'étape 2 n'est pas illustrée) sont enchaînées à l'aide de :
- un séquenceur de données 70, qui permet de gérer le flot des K données entrantes ($v_k$, $n_k$)
- un séquenceur de classes 71, qui permet de parcourir les $N_C$ classes ;
- un séquenceur de cellules 72, qui permet de parcourir les N représentants et cellules associées ;
- un séquenceur-instructions 74 qui assure l'enchaînement des traitements. D'autre part, un jeu de mémoires de travail 73 assure le tamponnement des données entre chaque étape.

Chacune des chaînes de circuits et modules permettant de réaliser les étapes 1 à 5 va maintenant être décrite, avant de commenter le fonctionnement général du dispositif illustré dans le diagramme de la figure 7.

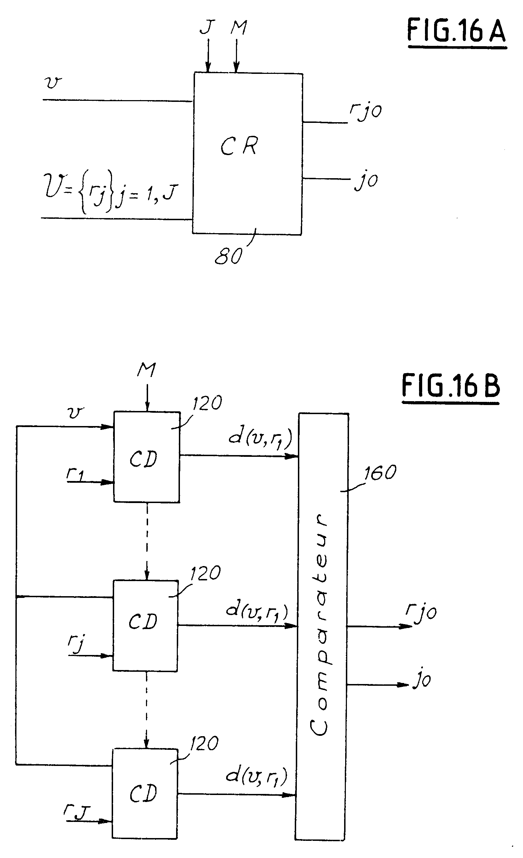

La figure 8 représente la logique de connexion permettant de réaliser l'étape 1 du procédé de la figure 3, consistant à répartir les données entrantes ($v_k$, $n_k$) dans l'ancienne partition. Les vecteurs $v_k$ sont introduits dans un module 80 de calcul du représentant, illustré en figure 16. Ce module 80 fonctionne en association avec la mémoire MEM-TD 171 de stockage de la taille des sous-dictionnaires $N_K$.

La constitution du module 80 est explicitée dans les figures 16a, 16b. D'une manière générale, on notera que les figures 12 à 16, qui explicitent la constitution de différents modules du dispositif mettant en oeuvre l'invention, sont constituées chacune d'un rappel synthétique des entrées et sorties du module (figures 12a, 13a, 14a, 15a et 16a), puis d'une figure explicitant l'architecture interne du module (figures 12b, 13b, 14b, 15b, et 16b).

Le module 80 de l'étape 1 est constitué selon la figure 16b de modules de calcul de distorsion 120 montés en parallèle. La distorsion entre le vecteur entrant v et chaque représentant du sous-dictionnaire est calculée, et un circuit comparateur 160 permet de détecter le représentant offrant le minimum de distorsion, c'est-à-dire le réprésentant de la cellule à laquelle appartient le vecteur v.

Le circuit 80 de l'étape 1, illustré en figure 8, est également alimenté par l'information de classification $n_k$ du vecteur $v_k$, via un dispositif de calcul d'adresses 81, qui vient pointer sur l'adresse $a_k$ de la mémoire MEM-D 170 de stockage des sous-dictionnaires.

Les circuits et modules de l'étape 1, illustrés en figure 8, incluent également la mémoire MEM-CC 172 assurant le comptage d'occurence des représentants, et la mémoire MEM-CR 173 assurant le comptage d'occurence des classes. Ces mémoires 172, 173 sont incrémentées d'une unité à chaque calcul du représentant d'un nouveau vecteur $v_k$.

Les circuits permettant la mise en oeuvre de l'étape 2 ne sont pas représentés, ces circuits se résumant à la lecture continue de la mémoire MEM-CC 172, une fois le flot de données ($v_k$, $d_k$) traité par l'étape 1. Le contenu de cette mémoire 172 fournit en effet le cardinal de jeu de vecteurs d'observations.

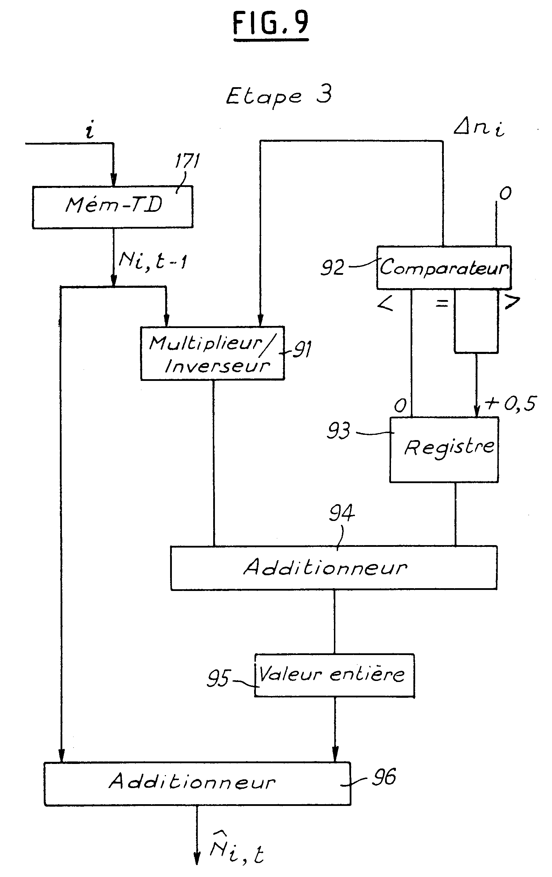

La figure 9 illustre un circuit de mise en oeuvre de l'étape 3, consistant à estimer la taille des nouveaux sous-dictionnaires, à partir du jeu de vecteurs d'observations.

Le circuit représenté correspond à l'exécution du traitement sur la classe i. L'information de classe i est introduite dans la mémoire MEM-TD 171, qui restitue la taille du sous-dictionnaire précédent de la classe. Cette information est fournie à un multiplieur inverseur 91, qui est également alimenté par la valeur $\Delta n_i$ de la différence entre le cardinal de l'ancien sous-dictionnaire et le cardinal du nouveau. La valeur $\Delta n_i$ est également fournie à un circuit comparateur 92 qui incrémente un registre 93 lorsque la taille du nouveau dictionnaire est supérieure ou égale à 0.

Le multiplieur 91 et le registre 93 alimentent un circuit additionneur 94, suivi d'un circuit 95 d'extraction de la valeur entière du signal fourni par l'additionneur. La taille du nouveau sous-dictionnaire $\hat{N}_{i,t}$ est fournie par un second circuit additionneur 96 des signaux de sortie de la mémoire 171 et du circuit 95.

L'étape 4 est représentée sur les figures 10 et 10bis. Cette étape correspond au rafraîchissement du sous-dictionnaire de la classe i.

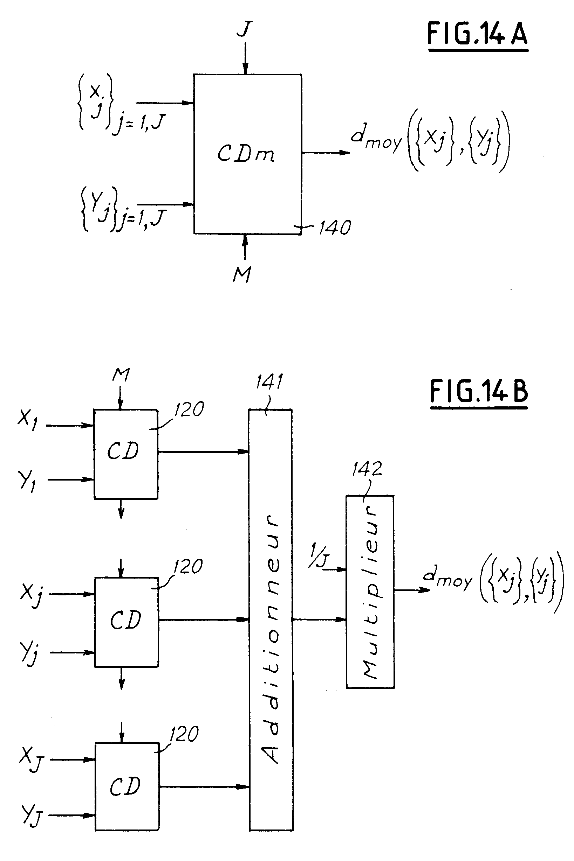

Les données d'entrée sont, à cette étape, la valeur de la distorsion maximale admissible $d_i$, le contenu du sous-dictionnaire $E_{i,t-1}$ de la classe i, ainsi que le jeu de vecteurs d'observation $(v_k, n_k)$. Le circuit 101 calcule tout d'abord la distorsion moyenne sur l'ensemble du sous-dictionnaire. Ce circuit 101 est détaillé en figures 14a, 14b, et est constitué de plusieurs circuits 120 de calcul de distorsion. Chaque circuit 120 calcule la distorsion entre chaque vecteur d'observation et son représentant, et l'ensemble des circuits 120 montés en parallèles alimentent un circuit additionneur 141 suivi d'un circuit multiplieur 142 qui fournit l'information de distorsion moyenne $d_{moy}$, sur la classe.

L'étape 4 de la figure 10 se poursuit à travers un circuit comparateur 102 qui interrompt le traitement de rafraîchissement dans le cas où la distorsion moyenne sur la classe est inférieure ou égale à la distorsion maximale admissible $d_i$.

Dans le cas contraire, le séquenceur de cellules 72 est activé pour identifier les cellules dont la distorsion moyenne est supérieure à une distorsion maximale $d_{max}$ déterminée par registre 103 et table 104 en relation avec le seuil de distorsion $d_i$. A cet effet, un circuit comparateur 105 extrait la valeur de distorsion de chaque cellule stockée dans la mémoire MEM-$D_{mc}$ 174, pour la comparer à l'information de distorsion maximale issue de la table 104.

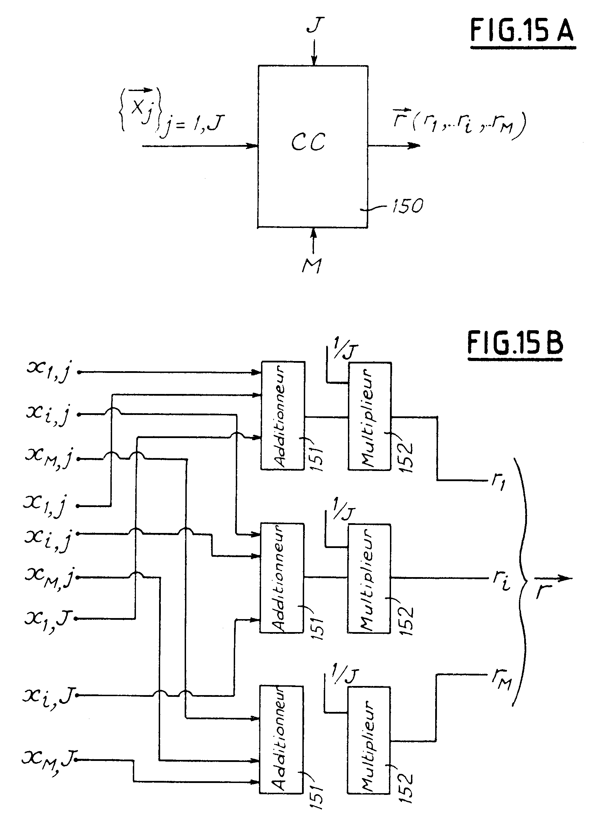

La sortie du comparateur 105 correspondant à un test positif est reliée à l'entrée d'un module 150 assurant le rafraîchissement du représentant de la cellule sélectionnée. Ce circuit 150 est détaillé en figure 15b, et est constitué d'une multiplicité de circuits additionneurs 151 est alimenté par les coefficients de même rang de l'ensemble des vecteurs de la cellule, et chacun des circuits multiplieurs 152 fournit la nouvelle valeur du coefficient de même rang du nouveau vecteur représentant.

Chaque nouveau représentant est ensuite fourni à un circuit de calcul de distorsion 120, comme illustré en figure 10bis. La sortie du circuit de calcul de distorsion 120 est connectée à l'entrée d'un comparateur 106 qui permet d'explorer le voisinage proche et le voisinage très proche de la cellule sélectionnée, en coopération avec deux compteurs 107 et deux registres 108 le le bornage de l'opération d'exploration étant assuré par circuit additionneur 109 et comparateur 200.

Un comparateur 201 oriente ensuite le traitement soit vers un circuit de rafraîchissement 180a par application de l'algorithme LBG et de techniques de découpage (cas où aucun représentant n'a été identifié dans le voisinage proche de la cellule), soit vers des circuits 150-180 de recalcul du centroïde de la cellule fusionnée, et de repartitionnement du voisinage par algorithme LBG, et techniques de découpage respectivement.

Le module 180 correspondant est représenté en Fig. 18. Dans le cas général d'utilisation du module, les entrées sont constituées du dictionnaire initial (ou d'une fraction de celui-ci) E init, d'un seuil maximal admissible de distorsion $D_{max}$ formant critère d'arrêt, et d'une consigne de déclenchement "valid". La sortie est constituée par le dictionnaire (fraction de dictionnaire) rafraîchi, E optimisé.

Les nouveaux représentants calculés sont alimentés vers la mémoire MEM-D 170 des vecteurs représentants.

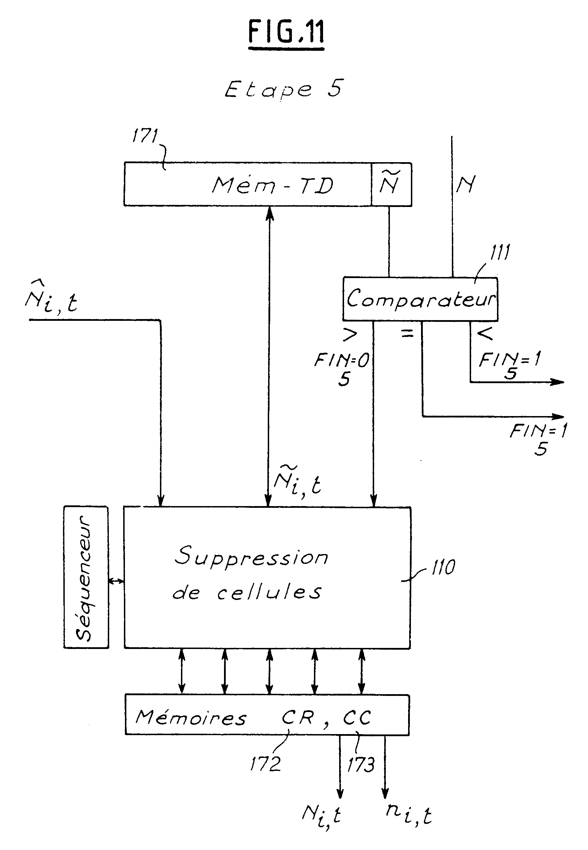

L'étape 5 est représentée en figure 11. Elle est réalisée à l'aide d'un module de suppression de cellules 110, commandé par séquenceur et connecté à la mémoire MEM-TD 171. Le modèle de suppression de cellule 110 fonctionne en coopération avec les mémoires CR et CC 172, 173, fournissant les informations d'occurrence des classes, et des représentants respectivement. Un circuit comparateur 111 interrompt le processus de rafraîchissement lorsque le cardinal du nouveau dictionnaire concaténé est revenue en-deçà du seuil limite N.

La figure 12 présente un mode de réalisation des modules de calcul de distorsion 120 utilisés dans les étapes 1 et 4. Chacun de ces modules est constitué de soustracteurs 121 montés en parallèle, et connectés chacun en sortie à un circuit multiplieur 122. Tous les multiplieurs 122 aboutissent ensuite à un cricuit additionneur 123 connecté à un circuit multiplieur 124 fournissant la valeur de distorsion entre les deux vecteurs X, Y.

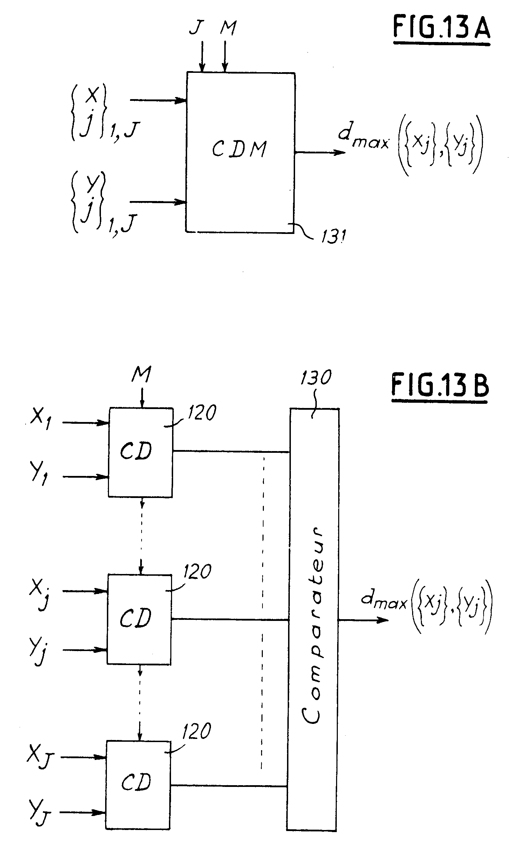

La figure 13 représente un module 131 de calcul de distorsion maximale utilisable pour identifier et sélectionner les cellules à forte distorsion. Ce module est constitué de plusieurs modules 120 de calcul de distortion, montés en parallèles et aboutissant à un comparateur 130, dont la sortie fournit la valeur de distorsion maximale recherchée.

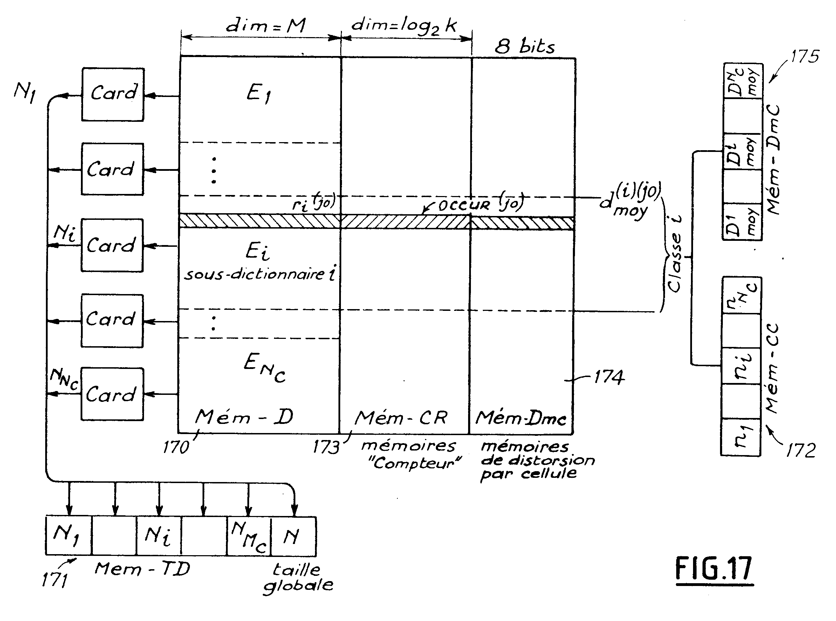

La figure 17 illustre le partitionnement de la mémoire MEM-D 170, qui stocke le dictionnaire E, formé de la concaténation des sous-dictionnaires $E_i$.

A chaque représentant-vecteur $r_{i,jo}$, apparatenant à la classe i, et stocké dans la mémoire MEM-D 170, il est associé une valeur d'occurrence qui équivaut au nombre d'utilisations du représentant-vecteur pour le flot de données entrantes $(v_k, n_k)$. Ces valeurs d'occurrence sont produites par comptage, comme mentionné en relation avec la figure 8, et sont stockées dans la mémoire MEM-CR 173 qui est de taille N, identique à la taille du dictionnaire global E.

L'occurrence des classes pour le flot de données entrantes est mémorisée, comme déjà mentionné, dans la mémoire MEM-CC 172.

La mémoire MEM-TD stocke la taille de chaque sous-dictionnaire $E_i$, ainsi que la taille globale du dictionnaire concaténé N.

Enfin, les mémoires MEM-D$_{mc}$ et MEM-D$_{mC}$ stockent les valeurs de distorsion moyenne pour chaque cellule et chaque classe. Comme déjà noté précédemment, le calcul des distorsions moyennes s'effectue en prenant en compte les valeurs d'occurrence des représentants et des classes, rexpectivement stockées dans MEM-CR 173, et MEM-CC 172.

On notera que dans le cadre de l'utilisation du procédé dans un schéma de codage-décodage, du type de celui de la figure 1, seule la mémoire MEM-D 170 est présente au décodeur, les autres étant nécessaires uniquement au procédé de rafraîchissement mis en oeuvre en amont du codeur.

Un exemple de mise en oeuvre du procédé de codage adaptatif suivant l'invention a été réalisé sur une séquence d'image.

Le procédé a été mis en oeuvre en utilisant une transformation de chaque image par "transformée discrète Cosinus", sur blocs carrés d'image 4 x 4. La dimension retenue pour les vecteurs était de 15, et le nombre de vecteurs d'observation en entrée : K = 11256, soit une trame d'image décomposée en blocs 4 x 4.

Les blocs ont été répartis en 17 classes, et la taille du dictionnaire global a été limitée N = 4096 (exprimable en mots de 12 eb).

Les valeurs de distorsion par classes retenues étaient:
- 11, pour la classe 1 ;
- 16 pour les classes 5, 7, 9 et 11 ;
- 49 pour les autres classes.

Les paramètres de mise en oeuvre de l'étape 4 étaient :
- calcul de chaque nouveau seuil de distorsion $d_{max}$ = $d_{max}$/l,l, avec une initialisation à $d_{max}$ = $4d_i$ ;
- $P_{max}$ = 1 (limitation de l'exploration du voisinage de chaque cellule sélectionnée au seul représentant le plus proche) ;
- les valeurs des rayons $f_{min}$ et $f_{max}$ de la boule d'exploration centrée sur chaque représentant des cellules sélectionnées étaient de $d_i$ et 2,5 fois $d_i$ respectivement.

Les simulations ont été réalisées sur un miniordinateur VAX 11/750, muni d'un processeur vectoriel. Cet ordinateur possède une puissance de calcul de 0,7 MIPS (méga-instructions programme par seconde).

Le traitement du rafraîchissement du dictionnaire E sur une trame de la séquence traitée (séquence Voiture) a été effectué en moyenne en 1,5 minute. La table 2 présente les résultats de codage, par classe, pour le codage de la première trame des images 1, 10, 20 et 30 de la séquence. Les chiffres présentés en colonnes correspondent successivement au numéro de la classe, à l'image considérée, à la population de chaque classe dans l'image t en comparaison de l'image t-1, le nombre de représentants rafraîchis, la taille du dictionnaire, et les distorsions moyennes et maximales observées sur la classe.

Il est à noter que dans les simulations réalisées, aucune notion de parallélisme des traitements n'a été introduite, tant en ce qui concerne la gestion parallèle de chaque classe, que le séquencement et le rafraîchissement des cellules. Il existe donc une marge considérable de gain de temps par rapport au temps de calcul observé. De plus, en utilisant des procédures de recherche de représentants par arbre binaire, et éventuellement des quantifications vectorielles en cascade, la réalisation du dispositif, sous forme câblée, permettra de suivre des fréquences d'échantillonnage voisines de 13,5 MHz, qui corespondent aux standards actuels en télévision numérique.

TABLE 2 : RESULTATS DE CODAGE SUR UNE SEQUENCE D'IMAGES

(SEQUENCE "VOITURE")

| Classe | Image t (Trame 1) | Nb Blocs t-1/t | Nb Rep. rafraî. | Taille Dico t-1/t | Dmoyen ss/av raf | Dmax ss/av raf |
|---|---|---|---|---|---|---|
| 1 | Voit1 | - /1492 | - | - /2 | 23/- | 83/- |
|   | Voit10 | 1552/1568 | 0 | 2/2 | 23/23 | 77/77 |
|   | Voit20 | 1659/1680 | 0 | 2/2 | 22/22 | 79/79 |
|   | Voit30 | .756/1792 | 0 | 2/2 | 22/22 | 85/85 |
| 2 | 1 | - /77 | - | - /32 | 37/- | 105/- |
|   | 10 | 91/84 | 15 | 29/30 | 84/45 | 203/134 |
|   | 20 | 59/66 | 14 | 29/23 | 84/45 | 172/160 |
|   | 30 | 81/87 | 18 | 31/31 | 91/44 | 184/123 |
| 3 | 1 | - /55 | - | - /43 | 36/- | 191/- |
|   | 10 | 67/60 | 31 | 48/49 | 355/30 | 2713/204 |
|   | 20 | 51/55 | 34 | 4../.. | 524/37 | 8021/207 |
|   | 30 | .1/46 | 22 | 49/35 | 398/.9 | 2309/259 |
| 4 | 1 | - /16 | - | - /16 | 0/- | 0/- |
|   | 10 | 20/17 | 2 | 7/5 | 77/47 | 152/107 |
|   | 20 | 10/16 | 2 | 4/6 | 91/37 | 197/85 |
|   | 30 | 25/13 | 6 | 8/7 | 72/20 | 106/33 |
| 5 | 1 | - /274 | - | - /120 | 40/- | 195/- |
|   | 10 | 317/316 | 80 | 143/133 | 130/45 | 1150/202 |
|   | 20 | 314/327 | 89 | 139/145 | 131/41 | 1034/149 |
|   | 30 | 255/358 | 91 | 126/138 | 138/45 | 817/176 |
| 6 | 1 | - /103 | - | - /16 | 42/- | 102/- |
|   | 10 | 106/83 | 8 | 22/18 | 62/47 | 193/96 |
|   | 20 | 92/94 | 8 | 26/21 | 58/47 | 140/103 |
|   | 30 | 74/76 | 5 | 20/17 | 56/49 | 113/107 |
| 7 | 1 | - /948 | - | - /426 | 43/- | 356/- |
|   | 10 | 916/911 | 249 | 453/444 | 141/41 | 3489/281 |
|   | 20 | 896/859 | 242 | 452/421 | 145/40 | 2036/247 |
|   | 30 | 845/836 | 230 | 393/409 | 149/40 | 2575/253 |
| 8 | 1 | - /10 | - | - /10 | 0/- | 0/- |
|   | 10 | 4/5 | 3 | 4/5 | 268/0 | 374/0 |
|   | 20 | 3/7 | 2 | 5/3 | 253/0 | 312/0 |
|   | 30 | 2/2 | 1 | 2/2 | 37/0 | 367/0 |
| 9 | 1 | - /16 | - | - /16 | 0/- | 0/- |
|   | 10 | 20/23 | 10 | 17/18 | 531/42 | 1155/127 |
|   | 20 | 16/17 | 11 | 15/15 | 1095/23 | 3395/177 |
|   | 30 | 25/11 | 12 | 22/11 | 758/0 | 1402/0 |
| 10 | 1 | - /3418 | - | -/128 | 50/- | 167/- |
|   | 10 | 3412/3379 | 26 | 171/175 | 50/48 | 165/162 |
|   | 20 | 3394/3463 | 0 | 156/152 | 49/49 | 165/165 |
|   | 30 | 3516/3458 | 0 | 158/155 | 49/49 | 163/163 |
| 11 | 1 | - /1217 | - | -/785 | 40/- | 248/- |
|   | 10 | 1162/1214 | 466 | 753/749 | 274/44 | 6474/275 |
|   | 20 | 1150/1134 | 437 | 764/716 | 245/43 | 4786/226 |
|   | 30 | 1117/1079 | 426 | 713/681 | 274/42 | 5705/183 |
| 12 | 1 | - /124 | - | -/4 | 47/- | 128/- |
|   | 10 | 142/134 | 0 | 7/7 | 43/43 | 113/113 |
|   | 20 | 122/116 | 0 | 6/6 | 48/48 | 149/149 |
|   | 30 | 129/127 | 0 | 6/6 | 45/45 | 93/93 |

| Classe | Image t (Trame 1) | Nb Blocs t-1/t | Nb Rep rafraî. | Taille Dico t-1/t | Dmoyen ss/av raf | Dmax ss/av raf |
|---|---|---|---|---|---|---|
| 13 | Voit1 | - /341 | - | - /210. | 23/-. | 276/- |
|  | Voit10 | 369/343 | 85 | 157/159 | 141/46 | 1396/147 |
|  | Voit20 | 377/328 | 76 | 139/137 | 141/144 | 2468/183 |
|  | Voit30 | 320/342 | 100 | 114/147 | 166/40 | 2798/150 |
| 14 | 1 | - /342 | - | - /16 | 43/- | 161/- |
|  | 10 | 332/345 | 0 | 18/18 | 47/47 | 163/163 |
|  | 20 | 344/334 | 0 | 18/18 | 47/47 | 136/136 |
|  | 30 | 347/329 | 0 | 19/19 | 46/46 | 156/156 |
| 15 | 1 | - /989 | - | - /441 | 45/- | 235/- |
|  | 10 | 979/939 | 244 | 476/428 | 176/48 | 3036/259 |
|  | 20 | 984/930 | 263 | 479/435 | 179/45 | 2444/189 |
|  | 30 | 907/936 | 278 | 458/441 | 192/46 | 2828/276 |
| 16 | : | - /756 | - | - /128 | 46/- | 141/- |
|  | 10 | 784/796 | 87 | 222/209 | 65/47 | 185/150 |
|  | 20 | 776/785 | 99 | 211/214 | 69/46 | 190/165 |
|  | 30 | 777/769 | 102 | 212/214 | 69/46 | 190/150 |
| 17 | 1 | - /1078 | - | - /717 | 43/- | 390/- |
|  | 10 | 987/1040 | 444 | 689/721 | 290/43 | 5772/295 |
|  | 20 | 1012/1033 | 497 | 754/762 | 296/34 | 6084/222 |
|  | 30 | 1009/995 | 460 | 716/711 | 318/39 | 4494/218 |

**Rafraichissement total:**

    **Voit10: 1750 représentants**

    **Voit20: 1774 représentants**

    **Voit30: 1751 représentants**

**Taille globale du dictionnaire:**

    **Voit10: 3170 représentants**

    **Voit20: 3126 représentants**

    **Voit30: 3024 représentants**

## Revendications

**1.** Procédé de codage adaptatif d'un signal numérique (10) par quantification vectorielle, destiné notamment à permettre de maximiser la qualité du signal codé sous la contrainte d'un débit d'information limité, procédé du type consistant à partitionner en cellules (22) l'espace des états possibles des composantes du signal (21), en choisissant un représentant unique (23) pour chaque cellule, et à substituer à chaque composante du signal (21) le représentant de la cellule à laquelle il appartient, l'ensemble des représentants qui résultent du partitionnement formant un dictionnaire, le procédé incluant un processus de rafraîchissement local du dictionnaire, dans lequel on sélectionne (54) les cellules pour lesquelles le codage d'un nouveau jeu de composantes du signal à l'aide du dictionnaire en cours se traduit par une distorsion supérieure à un certain seuil, caractérisé en ce que le processus de rafraîchissement local du dictionnaire comprend en outre les étapes suivantes :

- on explore (56) le contenu et l'occurrence d'emploi du dictionnaire par le nouveau jeu de composantes du signal sur chaque cellule ainsi sélectionnée, ainsi que sur le voisinage de ladite cellule sélectionnée constitué par au moins une cellule voisine à ladite cellule sélectionnée, et
- on reconfigure (57, 58, 59) le partitionnement local de ce voisinage considéré comme un ensemble de cellules interdépendantes par détermination d'un ou de plusieurs représentants (23) pour ledit ensemble.

2. Procédé selon la revendication 1, caractérisé en ce que ladite étape d'exploration et de reconfiguration du voisinage de la cellule sélectionnée consiste à distinguer d'une part un voisinage très proche (61) (proximité immédiate), et d'autre part un voisinage proche (simple proximité) (62), et à fusionner toutes les cellules dudit voisinage très proche avec un recalcul du nouveau représentant commun pour obtenir une cellule fusionnée, puis à rafraîchir en interdépendance toutes les cellules dudit voisinage proche, y compris la cellule fusionnée.

3. Procédé selon la revendication 2, caractérisé en ce que ledit rafraîchissement interdépendant de toutes les cellules du voisinage proche (62), y compris la cellule fusionnée, est réalisé par utilisation de l'algorithme LBG, et/ou de techniques de découpage des cellules.

4. Procédé selon l'une quelconque des revendications 1 à 3, caractérisé en ce que ladite quantification vectorielle utilisée est obtenue à l'aide d'un quantificateur vectoriel multiclasse (13), ledit dictionnaire étant constitué par la concaténation de sous-dictionnaires correspondant chacun à une des classes, et en ce que le rafraîchissement du dictionnaire est réalisé indépendamment pour chaque sous-dictionnaire.

5. Procédé selon la revendication 4, caractérisé en ce que la taille du dictionnaire concaténé est fixe, ledit procédé de codage adaptatif comprenant une étape d'arbitrage entre la taille des sous-dictionnaires rafraîchis, par suppression des représentants des cellules les moins utilisées.

6. Procédé selon la revendication 1 ou 4, caractérisé en ce que ladite sélection des cellules dont la distorsion correspondante est supérieure audit seuil s'effectue par rapport à un seuil de distorsion maximal admissible, abaissé itérativement (52, 54) jusqu'à obtention d'une distorsion moyenne acceptable sur l'ensemble du dictionnaire, sous-dictionnaire respectivement.

7. Procédé selon la revendication 4, caractérisé en ce qu'aucune opération de rafraîchissement n'est effectuée sur les sous-dictionnaires dont la distorsion moyenne est inférieure à un seuil de distorsion admissible.

8. Procédé selon la revendication 2, caractérisé en ce que ladite exploration du voisinage de chaque cellule sélectionnée consiste à identifier les P premiers représentants situés dans une boule centrée sur le représentant de la cellule fusionnée, de rayon égal à une distorsion maximale $f_{max}$ admissible, puis à distinguer, parmi lesdits P représentants, les P1 représentants contenus dans une boule de rayon $f_{min}$ ($f_{min} < f_{max}$), lesdits P1 représentants définissant ledit voisinage "très proche", et les P2 = P-P1, autres représentants définissant ledit voisinage proche.

9. Procédé selon la revendication 4, caractérisé en ce qu'il est appliqué au codage d'un signal d'image en télévision numérique, et en ce que ledit signal d'image est décomposé en blocs de 4 x 4 pixels, en ce qu'on prétraite lesdits blocs par transformation orthogonale, de type transformée Cosinus, en ce qu'on répartit lesdits blocs transformés en classes au moyen de grilles d'analyse de leur activité, et en ce qu'on échantillonne par zones lesdits blocs transformés classés, ladite classification et ledit échantillonnage des blocs étant effectués sur des critères de seuil de détection psychovisuelle de distorsion, déterminés expérimentalement, et en ce qu'on soumet enfin les blocs à la quantification vectorielle avec rafraîchissement indépendant des sous-dictionnaires de chaque classe.

10. Procédé selon la revendication 9, caractérisé en ce qu'il est appliqué au codage d'un signal d'image en télévision numérique à trames entrelacées, et en ce que des sous-dictionnaires spécifiques sont affectés aux trames paires, et aux trames impaires, respectivement.

**11.** Procédé selon la revendication 10, caractérisé en ce qu'on rafraîchi le dictionnaire pour chaque nouvelle trame du signal d'image.

**Claims**

1. Method for the adaptive coding of a digital signal (10) by vectorial quantization, intended in particular to permit a maximization of the quality of the coded signal under the constraint of a limited information flow, which method is of the type constituted by dividing the space of the possible states of the components of the signal (21) into cells (22), by choosing a single representative value (23) for each cell and by substituting the representative value of the cell to which it belongs for each component of the signal (21), the set of the representative values resulting from the division forming a dictionary, the method including a local refreshment process of the dictionary, wherein one selects (54) the cells in respect of which the coding of a new set of signal components by means of the current dictionary is reflected in a distortion exceeding a certain threshold, characterized in that the process of the local refreshment of the dictionary comprises, moreover, the following steps :
   - one explores (56) the content and occasion of use of the dictionary by the new set of signal components in each cell thus selected, as well as in the vicinity of the said selected cell constituted by at least one cell adjoining the said selected cell, and
   - one reconfigures (57, 58, 59) the local division of this vicinity in question as a set of interdependent cells by determining one or several representative values (23) for the said set.

2. Method according to claim 1, characterized in that the said step of exploring and reconfiguring the vicinity of the selected cell lies in distinguishing, on the one hand, a very close vicinity (61) (an immediate proximity) and, on the other hand, a close vicinity (62) (an ordinary proximity), and in merging all the cells of the said very close vicinity with a recalculation of the new common representative value so as to obtain a merged cell, and then in refreshing all the cells of the said close vicinity, including the merged cell, on an interdependent basis.

3. Method according to claim 2, characterized in that the said interdependent refreshment of all the cells of the close vicinity (62), including the merged cell, is effected by using the LBG algorithm and/or cell clipping techniques.

4. Method according to any one of claims 1 to 3, characterized in that the said vectorial quantization used is obtained by means of a multiclass vectorial quantizer (13), the said dictionary being constituted by the concatenation of the subdictionaries, each corresponding to one of the classes, and in that the refreshment of the dictionary is effected independently for each subdictionary.

5. Method according to claim 4, characterized in that the size of the concatenated dictionary is fixed, the said method of adaptive coding comprising a step of arbitration between the sizes of the refreshed dictionaries by suppression of the representative values of the least used cells.

6. Method according to claim 1 or 4, characterized in that the said selection of cells whose corresponding distortion exceeds the said threshold is effected in relation to a maximum admissible distortion threshold iteratively lowered (52, 54) until a mean distortion acceptable over the dictionary, subdictionary set respectively has been obtained.

7. Method according to claim 4, characterized in that no refreshment operation is effected in the subdictionaries whose mean distortion is less than an admissible threshold.

8. Method according to claim 2, characterized in that the said exploration of the vicinity of each selected cell lies in identifying the first representative values P situated in a sphere centred on the representative value of the merged cell, with a radius equal to a maximum admissible distortion $f_{max}$, then in distinguishing between the representative P values, the representative P1 values contained in a sphere with a radius of $f_{min}$ ($f_{min} < f_{max}$), the said P1 representative values defining the said "very close vicinity" and the P2 = P-P1, the other representative values, defining the said close vicinity.

9. Method according to claim 4, characterized in that it is applied to the coding of an image signal in digital television, and in that the said image signal is split into blocks of 4 x 5 pixels and that the said blocks are treated by orthogonal transformation of the cosine transform type, in that the said transformed blocks are divided into classes by means of grids analyzing their activity and that the said classified transformed blocks are sampled by zones, the said classification and the said sampling of the blocks being effected according to experimentally determined psychovisual criteria of the detection threshold of distortion, and that finally the blocks are subjected to the vectorial quantization with an independent refreshment of the subdictionaries of each class.

10. Method according to claim 9, characterized in that it is applied to the coding of a digital television signal with interlaced rasters and that specific subdictionaries are assigned to even rasters and odd rasters respectively.

11. Method according to claim 10, characterized in that the dictionary is refreshed for each new raster of the image signal.

**Patentansprüche**

1. Verfahren zur selbstanpassenden Codierung eines Digitalsignals (10) durch Vektorquantisierung, insbesondere für die Maximierung der Qualität des codierten Signals bei einem vorgegebenen begrenzten Informationsdurchsatz, wobei dieses Verfahren darin besteht, daß der Bereich der möglichen Zustände der Komponenten des Signals (21) in Zellen (22) mit Auswahl eines eindeutig bestimmten Repräsentanten (23) für jede Zelle aufgeteilt wird und daß jede Komponente des Signals (21) durch den Repräsentanten der Zelle, zu der er gehört, ersetzt wird, wobei die Gesamtheit der Repräsentanten, die sich bei dieser Aufteilung ergeben, ein Verzeichnis bildet und wobei das Verfahren einen Prozeß zur lokalen Auffrischung des Verzeichnisses beinhaltet, in dem die Zellen ausgewählt werden (54), bei denen die Codierung eines neuen Satzes von Signalkomponenten mit Hilfe des aktuellen Verzeichnisses in einer Verzerrung, die eine bestimmte Schwelle überschreitet, zum Ausdruck kommt, dadurch gekennzeichnet, daß der Prozeß zur lokalen Auffrischung des Verzeichnisses außerdem die folgenden Schritte umfaßt:
   - Abfrage (56) von Inhalt und Häufigkeit der Anwendung des Verzeichnisses durch den neuen Satz von Signalkomponenten in bezug auf jede auf diese Weise ausgewählte Zelle sowie in bezug auf die Umgebung dieser ausgewählten Zelle, wobei diese Umgebung aus mindestens einer der ausgewählten Zelle benachbarten Zelle besteht, und
   - Rekonfiguration (57, 58, 59) der lokalen Aufteilung dieser Umgebung, die als eine Gesamtheit von aufeinander bezogenen Zellen betrachtet wird, durch die Bestimmung, eines oder mehrerer Repräsentanten (23) für diese Gesamtheit.

2. Verfahren nach Anspruch 1, dadurch gekennzeichnet, daß der besagte Schritt der Abfrage und der Rekonfiguration der Umgebung der ausgewählten Zelle darin besteht, daß zum einen eine sehr nahe Umgebung (61) (unmittelbare Nähe) und zum anderen eine nahe Umgebung (einfache Nähe) (62) unterschieden wird und daß alle Zellen der besagten sehr nahen Umgebung mit einer Neuberechnung des neuen gemeinsamen Repräsentanten verschmolzen werden, so daß man eine verschmolzene Zelle erhält, wobei anschließend alle Zellen der besagten nahen Umgebung, einschließlich der verschmolzenen Zelle, interdependent aufgefrischt werden.

3. Verfahren nach Anspruch 2, dadurch gekennzeichnet, daß die besagte interdependente Auffrischung aller Zellen der nahen Umgebung (62), einschließlich der verschmolzenen Zelle, durch den Einsatz des LBG-Algorithmus' und/oder von Zellenausschnittechniken erfolgt.

4. Verfahren nach einem der Ansprüche 1 bis 3, dadurch gekennzeichnet, daß die benutzte Vektorquantisierung mit Hilfe eines Mehrklassen-Vektorquantifikators (13) erfolgt, wobei das besagte Verzeichnis durch die Verkettung von Unterverzeichnissen gebildet wird, die jeweils einer der Klassen entsprechen, und daß die Auffrischung des Verzeichnisses unabhängig für jedes Unterverzeichnis stattfindet.

5. Verfahren nach Anspruch 4, dadurch gekennzeichnet, daß die Größe des verketteten Verzeichnisses unveränderlich ist, wobei das selbstanpassende Codierungsverfahren einen Schritt in Form einer Zuweisungsentscheidung in bezug auf die Größe der aufgefrischten Unterverzeichnisse durch Unterdrückung der Repräsentanten der am seltensten benutzten Zellen umfaßt.

18

**6.** Verfahren nach Anspruch 1 oder 4, dadurch gekennzeichnet, daß die Auswahl der Zellen, deren jeweilige Verzerrung die vorgegebene Schwelle überschreitet, bezogen auf eine maximal zulässige Verzerrungsschwelle erfolgt, die fortschreitend abgesenkt wird (52, 54), bis sich eine zulässige mittlere Verzerrung, bezogen auf die Gesamtheit des Verzeichnisses bzw. des Unterverzeichnisses ergibt.

**7.** Verfahren nach Anspruch 4, dadurch gekennzeichnet, daß kein Auffrischungsvorgang an den Unterverzeichnissen erfolgt, deren mittlere Verzerrung unter einer zulässigen Verzerrungsschwelle liegt.

**8.** Verfahren nach Anspruch 2, dadurch gekennzeichnet, daß die Abfrage der Umgebung jeder ausgewählten Zelle darin besteht, daß die P ersten Repräsentanten erfaßt werden, die sich in einer Kugel befinden, welche mit einem Radius gleich einer maximal zulässigen Verzerrung $f_{max}$ um den Repräsentanten der verschmolzenen Zelle herum angeordnet ist, woraufhin dann aus den besagten Repräsentanten die $P_1$ Repräsentanten ausgewählt werden, die in einer Kugel mit einem Radius $f_{min}$ ($f_{min} < f_{max}$) enthalten sind, wobei diese $P_1$ Repräsentanten die "sehr nahe" Umgebung definieren, während durch die übrigen $P_2$ = $P-P_1$ Repräsentanten die nahe Umgebung definiert wird.

**9.** Verfahren nach Anspruch 4, dadurch gekennzeichnet, daß dieses Verfahren auf die Codierung eines digitalen Fernsehbildsignal angewendet wird und daß dieses Bildsignal aus einzelnen Bildblöcken mit 4 x 4 Pixel besteht, daß diese Bildblöcke durch orthogonale Transformation vom Typ Kosinus-Transformation vorbehandelt werden, daß die umgewandelten Bildblöcke anhand eines Analyserasters in bezug auf ihre Aktivität in Klassen eingeteilt werden und daß diese umgewandelten und in Klassen eingeteilten Bildblöcke nach Bereichen abgetastet werden, wobei die Einteilung in Klassen und die Abtastung der Bildblöcke nach experimentell ermittelten Kriterien in bezug auf die psychovisuelle Verzerrungswahrnehmungsschwelle erfolgt, und daß schließlich an den Bildblöcken die Vektorquantisierung mit unabhängiger Auffrischung der Unterverzeichnisse jeder Klasse vorgenommen wird.

**10.** Verfahren nach Anspruch 9, dadurch gekennzeichnet, daß dieses Verfahren auf die Codierung eines digitalen Fernsehbildsignals mit verschachtelten Rastern (Zeilensprung-Halbbild) angewendet wird und daß den geradzahligen und den ungeradzahligen Rastern jeweils spezifische Unterverzeichnisse zugeordnet werden.

**11.** Verfahren nach Anspruch 10, dadurch gekennzeichnet, daß das Verzeichnis für jeden neuen Bildsignalraster aufgefrischt wird.

## FIG.1

Signal d'entrée 10 → Découpage de l'image en blocs 11 → Transformation directe T 12 → Classification des blocs d'image 13 → Codeur vectoriel 14 → Canal de transmission 15 → Décodeur vectoriel 16 → Transformation inverse T⁻¹ 17 → Reconstruction de l'image 18 → Signal de sortie

# FIG.2

FIG.3

$(v_k, n_k)$

**Etape 1** — Répartition des données entrantes dans l'ancienne partition

**Etape 2** — Calcul des cardinaux des populations par classe

**Etape 3** — Estimation de la taille des nouveaux sous-dictionnaires

**Etape 4** — Rafraichissement local du sous-dictionnaire de la classe $i$ — $E_i^t$ — $i = 1, n_c$

**Etape 5** — Elaboration du nouveau dictionnaire global — $E_t$

# FIG.4

*"Ancien dictionnaire"*

$E_{t-1}$

40

Vecteurs d'observations

*Rafraichissement temporel local de dictionnaires*

$E_t$ *"Dictionnaire*

*"nouveaux"*

*"rafraichi"*

$(v_k, n_k)$

$\mathcal{E}$,

$N$

$N_c$

$(d_i)_{i=1, N_c}$

dim M,
métrique d.

*"Valid"*

$Einit$

$L BG + SPLT$

E optimisé

## FIG.18

$d_{max}$

## FIG.5

$E_{i,t-1}$

$\boxed{\begin{array}{c} Calcul \\ de \quad d_{moy}^{(i)} \end{array}}$ 51

52 $\quad d_{moy}^{(i)} < d_i$ oui / non

FIN

$\boxed{\begin{array}{c} Choix \ d'un \\ d_{max} \end{array}}$ 53

$\boxed{\begin{array}{l} Recherche \ des \\ cellules \ à \ distorsion \\ supérieures \ à \ d_{max} \end{array}}$ 54

$\boxed{Rafraichissement}$ 55

$\boxed{\begin{array}{c} Recherche \\ des \ voisins \\ locaux \end{array}}$ 56

très proche \quad proche \quad lointain

$\boxed{\begin{array}{c} Fusion \\ et \\ rafrai- \\ chisse- \\ ment \end{array}}$ 57

$\boxed{\begin{array}{c} Rafrai- \\ chisse- \\ ment \\ conjoint \end{array}}$ 58

$\boxed{\begin{array}{c} Rafrai- \\ chisse- \\ ment \\ isolé \end{array}}$ 59

$E_{i,t}$

24

## FIG.6

## FIG.6 Bis

$A_{TOT}$

$A_{SUP}$

$A_{LIG}$

$A_{DIAG}$

$A_{INF}$

$A_{COL}$

FIG.7

EP 0 276 603 B1

# FIG.8

Etape 1

$v_k$

Mém - TP _171_

$N_k$  M

(jo)

$r_{n_k, t-1}$

$n_k$  Dispositif de calcul d'adresses  $a_k$

_81_

$En_k, t-1$

Mém - D

_170_

CR

_80_

jo

incr=+1  Mém - CC  _172_

Mém - CR  incr=+1

_173_

# FIG.9

*Etape 3*

Etape 4

FIG.10

$d_i$   $E_{i,t-1}$   $\left(v_{\ell}, n_{\ell=i}\right)$

Mém - D   170

CDm   101

Comparateur   102

$<$   $=$   FIN$_4$ = 1   FIN$_4$ = 0

Registre   103

d max

$\lambda_i$   Tabulation   104

d max

Séquenceur cellule   72

174   $j_0$

Mém - Dmc

105

Comparateur

$>$   $=$   $<$

150

CC   Séquenceur   $v_{\ell}$
(j$_0$)

$\widehat{r}_{i,t}^{(j_0)}$

# FIG.10 Bis

# FIG.11

*Etape 5*

*171* Mém - TD  $\widetilde{N}$   $N$

$\widehat{N}_{i,t}$

*111* Comparateur

$>$  $=$  $<$

FIN=0  FIN=1
5  5

FIN=1
5

$\widetilde{N}_{i,t}$

Séquenceur

Suppression de cellules  *110*

Mémoires  CR , CC

*172*  *173*

$N_{i,t}$  $n_{i,t}$

## FIG.12 A

## FIG.12 B

FIG.13 A

FIG.13 B

## FIG.14 A

$$d_{moy}\left(\left\{x_j\right\}, \left\{y_j\right\}\right)$$

CDm

$\left\{\begin{matrix} x \\ j \end{matrix}\right\}_{j=1,J}$

$\left\{Y_j\right\}_{j=1,J}$

140

J

M

## FIG.14 B

$X_1$

$Y_1$

CD 120

M

$X_j$

$Y_j$

CD 120

$X_J$

$Y_J$

CD 120

Additionneur 141

Multiplieur 142

1/J

$$d_{moy}\left(\left\{x_j\right\}, \left\{y_j\right\}\right)$$

FIG.15 A

FIG.15 B

## FIG.16 A

## FIG.16 B

**FIG.17**